# EUROPEAN PATENT APPLICATION

(11) **EP 3 091 661 A1**
(43) Date of publication of application: **09.11.2016**
(21) Application number: 16168273.7
(22) Date of filing: 04.05.2016
(51) Int. Cl.: H03K 17/06

(54) **TRIAC CONTROLLING CIRCUIT FOR SMALL DOMESTIC APPLIANCES**

(30) Priority: 08.05.2015 SI 201500121
(71) Applicant: BSH Hausgeräte GmbH, 81739 München (DE)
(72) Inventor: Kostomaj, Adam, 3213 Frakolovo (SI); Pacnik, Roman, 2383 Smartno pri Slovenj Gradcu (SI); Vodopivec, Sebastijan, 5000 Nova Gorica (SI)

(57) **Abstract**

A triac or other controlling active element circuit for small domestic appliances, wherein that an AC signal must be applied to the triggering line of the active element in order to trigger the active element. The circuit is not triggered by application of a DC.

## Description

### Background of the invention

The present invention relates to the field of electrical circuits, specifically to triac controlling circuits.

### State of the art

Most small kitchen appliances, such as kitchen machines, food processors, stick mixers, specialized appliances, require sophisticated electronic control means which include microprocessors. The use of triggering means using electrical current is widely spread including circuits including one or more triacs or other active components.

The solution which is usually used for such kind of circuits is that microcontroller is connected directly or through some serial resistor to the driving pin of the triac. If the triac requires more current then additional output pins of microcontroller are connected in parallel (e.g. 1-3 pins in parallel are usually used).

It is often problematic that the triac may be uncontrolledly triggered or damaged by the trigger signal that does not have appropriate form and frequency.

### Problem to be solved

The object underlying the present invention is to provide a circuit which prevents uncontrolled triggering or supply of the triac in case of malfunction of circuit components (e.g. Microcontroller, triac...).

### Solution according to the invention

In order to achieve the object underlying the invention, the present invention provides a triac controlling circuit for small domestic appliances according to claim 1. Advantageous embodiments that can be implemented by themselves or in combination are described in dependent claims.

According to an aspect of an invention, a triac or other controlling active element controlling circuit for small domestic appliances, wherein an AC signal must be applied to the triggering line of the active element in order to trigger the active element is dislosed.

The objective of the invention is achieved through addition of an element in the triggering line of the triac, such as, but not limited to, a capacitor which prevents uncontrolled triggering or supply of the triac in case of malfunction of circuit components (e.g. Microcontroller, triac...), especially in case a DC signal is applied to the triac line by or through a microcontroller instead of the desired AC signal.

### Embodiments of the invention

According to a preferred embodiment, the triggering line comprises at least one resistor and at least one capacitor. The configurations can be very versatile to fit the desired threshold for blocking signals. These include implementation various numbers of resistors, capacitors and even other active elements in serial or parallel configurations.

In another preferred embodiment, the triggering line comprises no resistors and at least one capacitor. In some embodiments, specifically to reduce costs and complexity of the circuitry it may be beneficial to implement one or more capacitors and omit resistors altogether.

Additionally, the triggering line comprises at least two capacitors in a serial or parallel configuration in order to increase resistance in case of application of a DC current thus preventing triggering of the triac. Implementing two or more capacitors or other elements to a similar function is desirable to increase the impedance of the triggering line circuitry and to increase the protection threshold in case of an applied DC.

Additionally, the triggering line is not triggered by an application of a DC signal. It is the object of the invention to prevent triggering of the triac in case an unwanted DC signal is sent from the microcontroller or through the microcontroller in case of a malfunction or other events not designed to trigger the triac.

Advantageous embodiments and developments which can be used individually or in combination with one another are the subject matter of the dependent claims.

### Brief description of the drawings

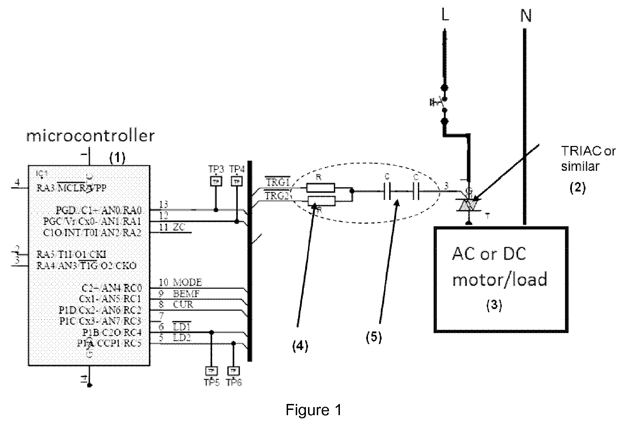

Figure 1: Schematic diagram of the triac controlling circiut

### Detailed description of the invention

The solution according to the present invention is designed to allow triggering of the triac by applying an alternating current (AC) signal to the triac line (G; gate) and prevent triggering through application of a direct current (DC) signal to the triac line. This is achieved through implementation of at least one additional capacitor (C) which is connected in addition to at least one resistor (R) in line with the triggering line of the triac. Such topology requires a suitable trigger signal of appropriate frequency (capacitor does not conduct direct current) - appropriate signal is provided by the microcontroller. Such topology represents very high impedance to DC signals/current or to signals with line frequency (50 Hz - 60 Hz) and prevents the triac from triggering when a DC signal is applied to the triggering line of the triac. A DC signal may be a result of a malfunction or failure and might not only trigger the triac unwontedly, but also damage it or other components.

Such a topology of triggering circuit has the following advantages. The triggering circuit does not conduct DC (Direct Current) signals and the microcontroller (µC) is protected from currents (I) and voltage (U) surges in the case of switching operations or failures of the triac. If the trigger signal does not have appropriate form and frequency then it is unable to trigger the triac or a similar active element and to turn on the device - e.g. failure of the microcontroller can't cause the appliance to operate when it is not desired. The same applies if the trigger signal does not have an appropriate form and frequency to trigger the triac or similar active element to turn on the device in case of a software cycling error (bug). Such circuit is also more robust and immune to outside influences which could cause unwanted triggering of the triac.

Such circuit topology is not limited to the use for triacs, but can also be used for controlling other active elements, e.g. transistor, SCR's, FET, MOSFET, relay ...

In Figure 1, a schematic diagram of the triac controlling circuit is shown. The microcontroller 1 provides a signal through one or more pins to the triggering line of the triac 2. The line includes one or more resistors 4 and one or more capacitors 5 (two are shown in the figure). A higher number of capacitors 5 provides greater security from being triggered with a DC signal. Through the capacitor(s) 5, the signal reaches the triac 2. It should be noted that for a current to arise in such a configuration n alternating current is required as an output from the microcontroller 1 since a DC current is effectively blocked by capacitors 5. The triggering line may be adapted by the use of appropriate resistors and capacitors to fit the needs regarding the applied frequency, voltage and currents, for the use in small household appliances, the preferred range of frequency is around 50 - 60 Hz and from 200 - 2.000 W. In the presented embodiment, the AC signal is generated by the microcontroller and does not require an additional source of the AC to be fitted to the appliance.

## Claims

1. A triac or other controlling active element controlling circuit for small domestic appliances, **characterized in that** an AC signal must be applied to the triggering line of the active element in order to trigger the active element.

2. The controlling circuit according to claim 1, **characterized in that** the triggering line comprises at least one resistor and at least one capacitor.

3. The controlling circuit according to claim 1, **characterized in that** the triggering line comprises no resistors and at least one capacitor.

4. The controlling circuit according to any of the previous claims, **characterized in that** the triggering line comprises at least two capacitors in a serial or parallel configuration in order to increase resistance in case of application of a DC current thus preventing triggering of the triac.

5. The controlling circuit according to any of the previous claims, **characterized in that** the triggering line is not triggerd by an application of a DC signal.
